# EUROPÄISCHE PATENTANMELDUNG

(11) **EP 4 194 876 A1**
(43) Veröffentlichungstag der Anmeldung: **14.06.2023**
(21) Anmeldenummer: 21213341.7
(22) Anmeldetag: 09.12.2021
(51) Int. Cl.: G01R 33/56

(54) **KOMPENSATIONSSCHNITTSTELLE FÜR EIN MAGNETRESONANZBILDGEBUNGSSYSTEM**

(71) Anmelder: Siemens Healthcare GmbH, 91052 Erlangen (DE)
(72) Erfinder: Hölscher, Uvo, 91056 Erlangen (DE); Forman, Christoph, 91080 Uttenreuth (DE); Gall, Peter, 91080 Uttenreuth (DE)

(57) **Zusammenfassung**

Es wird eine MR-System-Kompensationsschnittstelle (20) beschrieben. Die MR-System-Kompensationsschnittstelle (20) weist eine Hardware-Subschnittstelle (21) zum Empfangen von individuellen Hardwareparametern (HP) von einer individuellen Scaneinheit (102) eines MR-Systems (200) auf. Teil der MR-System-Kompensationsschnittstelle (20) ist auch eine Modellermittlungseinheit (22), welche dazu eingerichtet ist, ein Imperfektionsmodell (IM) auf Basis der Hardwareparameter (HP) zu ermitteln. Die MR-System-Kompensationsschnittstelle (20) umfasst weiterhin eine Kompensationsmodell-Ermittlungseinheit (23) zum Ermitteln eines Kompensationsmodells (KM) auf Basis des Imperfektionsmodells (IM), eine Applikations-Subschnittstelle (24) zum Empfangen von einer Applikation zugeordneten Applikationsdaten (AD) und eine Kompensationseinheit (25) zum Ermitteln von kompensierten Applikationsdaten (KAD) auf Basis der empfangenen Applikationsdaten (AD) und dem ermittelten Kompensationsmodell (KM). Es wird auch eine MR-System-Steuereinrichtung (13) beschrieben. Außerdem wird ein Magnetresonanzbildgebungssystem (200) beschrieben. Ferner wird ein Verfahren zur Ermittlung einer kompensierten Ansteuersequenz eines Magnetresonanzbildgebungssystems (200) zur Erzeugung von Magnetresonanzbilddaten (BD) eines Untersuchungsobjekts (P) beschrieben.

## Beschreibung

Die Erfindung betrifft eine MR-System-Kompensationsschnittstelle. Die Erfindung betrifft auch eine MR-System-Steuereinrichtung. Ferner betrifft die Erfindung ein Magnetresonanzbildgebungssystem. Außerdem betrifft die Erfindung ein Verfahren zum Ermitteln einer kompensierten Ansteuersequenz eines Magnetresonanzbildgebungssystems zur Erzeugung von Magnetresonanzbilddaten eines Untersuchungsobjekts.

Mit Hilfe moderner bildgebender Verfahren werden häufig zweioder dreidimensionale Bilddaten erzeugt, die zur Visualisierung eines abzubildenden Patienten und darüber hinaus auch für weitere Anwendungen genutzt werden können. Ein besonders gesundheitsschonendes Bildgebungsverfahren, insbesondere, weil es ohne Strahlenbelastung auskommt, ist die Magnetresonanzbildgebung.

In einer Magnetresonanzanlage, auch Magnetresonanztomographiesystem, Magnetresonanzbildgebungssystem oder kurz MR-System genannt, wird üblicherweise ein Untersuchungsbereich mit Hilfe eines Grundfeldmagnetsystems einem relativ hohen Grundmagnetfeld, beispielsweise von 0.55, 1.5, 3, 5 oder 7 Tesla, ausgesetzt. Zusätzlich wird mit Hilfe eines Gradientensystems ein Magnetfeldgradient angelegt. Über ein Hochfrequenz-Sendesystem werden dann mittels geeigneter Antenneneinrichtungen hochfrequente Anregungssignale (HF-Signale) ausgesendet, was dazu führen soll, dass die Kernspins bestimmter, durch dieses Hochfrequenzfeld resonant angeregter Atome um einen definierten Flipwinkel gegenüber den Magnetfeldlinien des Grundmagnetfelds verkippt werden. Bei der Relaxation der Kernspins werden Hochfrequenzsignale, so genannte Magnetresonanzsignale, abgestrahlt, die mittels geeigneter Empfangsantennen empfangen und dann weiterverarbeitet werden. Aus den so akquirierten Rohdaten können schließlich die gewünschten Bilddaten rekonstruiert werden.

Für eine bestimmte Messung ist damit eine bestimmte Pulssequenz auszuführen, welche aus einer Folge von Hochfrequenz-pulsen, auch RF-Pulse oder HF-Pulse genannt, insbesondere Anregungspulsen und Refokussierungspulsen sowie passend dazu koordiniert auszusendenden Gradientenpulsen in verschiedenen Raumrichtungen besteht. Zeitlich passend hierzu müssen Auslesefenster gesetzt werden, welche die Zeiträume vorgeben, in denen die induzierten Magnetresonanzsignale erfasst werden. Maßgeblich für die Bildgebung ist dabei insbesondere das Timing innerhalb der Pulssequenz, d. h. in welchen zeitlichen Abständen welche Pulse aufeinanderfolgen. Eine Vielzahl der Steuerparameter ist in der Regel in einem sogenannten Messprotokoll definiert, welches vorab mit Hilfe einer sogenannten Applikation erstellt wird und für eine bestimmte Messung beispielsweise aus einem Speicher abgerufen und ggf. vom Bediener mit Hilfe der Applikation vor Ort verändert werden kann, wobei der Bediener durch Eingabe zusätzliche Steuerparameter, wie beispielsweise einen bestimmten Schichtabstand eines Stapels von auszumessenden Schichten, eine Schichtdicke etc. vorgeben kann. Auf Basis all dieser Steuerparameter wird dann durch die Applikation eine Pulssequenz, die auch als Messsequenz bezeichnet wird, berechnet. Neben einer Funktionalität zur Ermittlung einer Pulssequenz umfasst eine Applikation auch eine Funktionalität bzw. Algorithmen zur Auswertung, insbesondere zur Bildrekonstruktion auf Basis von Rohdaten. Außerdem kann die Applikation Algorithmen zur Nachbearbeitung der Bilddaten (im Englischen Post-Processing) sowie eine Funktionalität zur Ermittlung eines sogenannten Workflows umfassen, der die Steuerung von Vorgängen und des Informationsflusses zwischen einzelnen Sequenzen und Rekonstruktionsvorgängen umfasst.

Bei der Magnetresonanzbildgebung erfolgt keine direkte Bildaufnahme im Ortsraum, sondern es werden zunächst Magnetresonanzsignale gemessen, deren Amplitude als Fourier-Transformierte der Bildaufnahme im k-Raum interpretiert werden kann. Der k-Raum ist der Ortsfrequenz-Raum der Dichteverteilung der magnetischen Momente in einem zu untersuchenden Bereich, in dem MR-Signale aufgenommen werden. Wird der k-Raum ausreichend abgetastet, so erhält man durch eine (bei schichtweiser Abtastung zweidimensionale) Fourier-Transformation die räumliche Verteilung der Dichte der magnetischen Momente. Dieser k-Raum wird während der Messung mit Rohdaten aufgefüllt, welche den erfassten Magnetresonanzsignalen nach Demodulation und Digitalisierung entsprechen.

Auf Basis der Rohdaten wird dann mit Hilfe einer Fourier-Transformation ein Bild von dem Untersuchungsbereich im Ortsraum rekonstruiert.

Die zur Bildgebung eingesetzte Applikation weist also die beiden Komponenten zur Erzeugung und Aufnahme von MR-Signalen, also die eigentliche Pulssequenz, und zur Rekonstruktion von Bilddaten auf Basis von Rohdaten auf.

Bei der Erstellung der Pulssequenz muss bekannt sein, welche Aufgaben der Scaneinheit, d.h. das Senden eines RF-Pulses, das Ausspielen eines Gradienten und die Aufnahme eines Messsignals, in welcher Reihenfolge und mit welchen Attributen, d.h. Flipwinkel, Gradientenamplitude, Dauer der Gradienten usw. erfolgen. Eine Pulssequenz spielt für den Vorgang der Bildgebung häufig mehrere Tausende dieser Aktionen aus. Durch die hohe Anzahl und die damit sich ergebende Möglichkeit an Variationen kann eine MR-Scaneinheit eine Vielzahl von unterschiedlichen Bildkontrasten erzeugen.

Bei der Rekonstruktion von Bilddaten muss bekannt sein, wie genau, d.h. insbesondere in welcher Reihenfolge und mit welchem Flipwinkel, die Pulssequenz die Aufnahme der Messsignale steuert. Häufige beruht der Rekonstruktionsprozess auf Teilprozessen, welche zum Beispiel eine Fourier-Transformation, einen Algorithmus zum Errechnen von Lücken im Datensatz bei der parallelen Bildgebung und einen Algorithmus zum Kombinieren von Signalen aus mehreren Empfangsspulen umfassen. In der Praxis werden aber abhängig von der Art der genutzten Sequenz noch viele weitere Algorithmen genutzt.

Die zur Bildgebung genutzte Magnetresonanzanlage, genauer gesagt die Scaneinheit der Magnetresonanzanlage, sowie das darin befindliche Untersuchungsobjekt, können als ideales physikalisches System aufgefasst werden, das durch ein allgemeines physikalisches Modell beschreibbar ist. Bei einem solchen idealen physikalischen System ist zum Beispiel das bereits erwähnte Grundmagnetfeld, auch B0-Feld genannt, absolut homogen, hat ein RF-Puls überall im Untersuchungsbereich den gleichen Flipwinkel oder werden Gradienten exakt mit dem durch eine Pulssequenz vorgegebenen Zeitverlauf ausgespielt. Mithin ist das ideale physikalische Modell für alle Scaneinheiten gleich, d.h. alle Scaneinheiten verhalten sich nach diesem Modell bei gleichem Grundmagnetfeld und derselben ausgespielten Pulssequenz absolut gleich.

Allerdings verhält sich das reale physikalische System einer Scaneinheit bei dem MR-Bildgebungsprozess nicht ideal, d.h. es verhält sich nicht so, wie es nach dem zugrundeliegenden allgemeinen physikalischen Modell zu erwarten wäre. Diese Abweichung liegt an individuellen "Imperfektionen" bzw. Abweichungen des jeweiligen realen physikalischen Systems von dem idealen physikalischen System. Beispielsweise weist das B0-Feld einer individuellen Scaneinheit bei einem individuellen Patienten individuelle Variationen auf, ist ein Flipwinkel immer ortsabhängig und wird ein ausgespielter Gradient immer durch Wirbelströme deformiert und durch Gradienten-Delays in der Zeit verzögert.

Die Hardware-Komponenten einer individuellen Scaneinheit ändern ihre Temperatur und haben somit unterschiedliche Kennlinien. Die Spulencharakteristiken driften zudem über die Zeit. Außerdem kann man einen RF-Puls nicht beliebig kurz oder mit beliebig hoher Amplitude ausspielen, da die Hardware der Scaneinheit Limits und bevorzugte Betriebsbereiche hat. Die genannten Abweichungen vom idealen physikalischen Modell hängen von den konkreten Hardware-Bauteilen einer Scaneinheit und dem Körperbau bzw. der Körperbeschaffenheit des Patienten in der Scaneinheit ab und variieren daher von Scaneinheit zu Scaneinheit und manchmal sogar von Patient zu Patient. Sie sind der Grund dafür, warum zwei Scaneinheiten unterschiedlichen Typs sich unterschiedlich verhalten. Auch bei Scaneinheiten desselben Typs zeigen sich Abweichungen, die jedoch kleiner ausfallen als bei unterschiedlichen Typen. Werden diese Abweichungen nicht berücksichtigt, so kommt es zu starken Artefakten und einer deutlich verschlechterten Bildqualität.

Bei der konkreten Anwendung einer Bildgebung mit einem Magnetresonanzbildgebungssystem wird also eine Kompensation der Abweichungen des realen physikalischen Systems vom idealen physikalischen System benötigt. Insbesondere ist es notwendig zu verstehen, welche Effekte durch welche Abweichungen auf die Pulssequenz und die Bildrekonstruktion ausgeübt werden und wie stark diese Effekte sind, um sie besser kompensieren zu können.

Einem Magnetresonanzbildgebungssystem kann eine sogenannte Architektur zugeordnet werden, die abstrakt das Zusammenwirken der Funktionalitäten des Magnetresonanzbildgebungssystems beschreibt. Die Kompensation der genannten Abweichungen erfolgt nun typischerweise an sehr unterschiedlichen Orten in dieser Architektur. Beispielsweise werden einige Effekte, wie zum Beispiel das Kompensieren von Abweichungen des B0-Feldes, auch "Shimmen" genannt, relativ hardwarenah abgefangen, ohne dass die individuelle Pulssequenz dadurch beeinflusst wird. Viele Effekte werden aber auch durch eine Änderung der Pulssequenz oder der Bildrekonstruktion kompensiert. Anders ausgedrückt, umfasst die für die Bildgebung eingesetzte Applikation, welche eine Funktionalität zur Erzeugung der Pulssequenz und zur Rekonstruktion eines Bildes umfasst, speziellen Code, mit dem die Kompensation durchgeführt wird.

Mithin weist herkömmlich jede Applikation individuellen Programmcode auf, wodurch die Kompensation auf die individuelle Applikation abgestimmt ist. Diese Vorgehensweise hat aber den Nachteil, dass jede Applikation ihre eigene Version der häufig doch sehr ähnlichen Kompensation umfasst und daher der Aufwand zur Programmierung einer individuellen Applikation sehr hoch ist.

Es gibt Ansätze, Bibliotheken für die Kompensation zu nutzen, auf die von mehreren Applikationen zugegriffen wird.

In Zukunft sollen aber Scaneinheiten von MR-Systemen eine standardisierte bzw. universelle Schnittstelle haben. Eine solche universelle Schnittstelle ist in der europäischen Patentanmeldung mit dem amtlichen Aktenzeichen 2021 6753 beschrieben. Die hierfür genutzten Applikationen sind dann einzeln gekapselt und dürfen keine gemeinsamen Bibliotheken nutzen. Dadurch werden unterschiedliche Applikationen unabhängig voneinander. Allerdings erhöht sich der Aufwand der Programmierung einer Applikation bei herkömmlicher Vorgehensweise dadurch erheblich.

Es besteht also die Aufgabe, Applikationen für die Magnetresonanzbildgebung mit reduziertem Aufwand möglichst unabhängig voneinander entwickeln zu können.

Diese Aufgabe wird durch eine MR-System-Kompensationsschnittstelle gemäß Patentanspruch 1, eine MR-System-Steuerungseinrichtung gemäß Patentanspruch 11, ein Magnetresonanzbildgebungssystem gemäß Patentanspruch 12 und ein Verfahren zum Ermitteln einer kompensierten Ansteuersequenz eines Magnetresonanzbildgebungssystems zur Erzeugung von Magnetresonanzbilddaten eines Untersuchungsobjekts gemäß Patentanspruch 13 gelöst.

Die erfindungsgemäße MR-System-Kompensationsschnittstelle umfasst eine Hardware-Subschnittstelle zum Empfangen von individuellen Hardwareparametern von einer individuellen Scaneinheit eines MR-Systems. Die Hardwareparameter umfassen individuelle oder typspezifische Daten einer Scaneinheit eines MR-Systems, welche mit Wirkmechanismen, die zu Abweichungen von einem idealen Verhalten der Scaneinheit des MR-Systems beitragen, zusammenhängen. Solche Daten können insbesondere Parameter einer Scaneinheit eines MR-Systems bzw. diesen Parametern zugeordnete Parameterwerte umfassen, mit denen ein physikalisches Modell, welches das nicht-ideale Verhalten einer Scaneinheit beschreibt, spezifiziert wird. Beispielsweise kann es zur Beschreibung von Wirbelströmen einer Scaneinheit ein physikalisches Modell geben, das eine mathematische Faltungsstruktur umfasst, bei der das Eingangssignal, beispielsweise ein Gradientensignal, gefaltet wird, so dass ein resultierendes Gradientenfeld mit Wirbelströmen herauskommt. Die für eine bestimmte Scaneinheit spezifischen Parameterwerte beschreiben die konkrete Ausprägung der Imperfektion bzw. die konkrete Ausprägung des abweichenden Verhaltens von einem idealen Verhalten der betreffenden Scaneinheit. Solche Parameterwerte können zum Beispiel nach der Fertigstellung der Scaneinheit vor deren Auslieferung ermittelt werden. Die Parameterwerte können aber auch nach der Auslieferung in vorbestimmten regelmäßigen Zeitabständen erneut ermittelt werden. Dieser Vorgang kann also als eine Art Kalibration der Scaneinheit verstanden werden. Beispielsweise kann für die Imperfektion der Wirbelströme als Hardwareparameter ein Datensatz ermittelt werden, welcher Zahlenwerte für die Faltungsfunktion des Imperfektionsmodells umfasst. Diese Zahlen können zum Beispiel während einer als "Tune-Up" bezeichneten Kalibration bei einer Installation der Scaneinheit in einem Krankenhaus ermittelt und abgespeichert werden.

Ein weiteres Beispiel für eine Abweichung von einem idealen Verhalten einer Scaneinheit wäre eine hardwarebedingte Gradientenverzögerung, die sich insbesondere bei der MR-Bildgebung mit nicht-kartesischen k-Raum-Trajektorien durch Artefakte in den rekonstruierten Bilddaten auswirkt. Als Gradientenverzögerung soll das im Vergleich zu dem Ausspielen der Pulssequenz zeitlich verzögerte Auftreten der Gradienten im MR-System bezeichnet werden. Auch diese hardwarespezifische Gradientenverzögerung kann durch Hardwareparameter ausgedrückt werden und über die Hardware-Subschnittstelle der MR-System-Kompensationsschnittstelle von einer bestimmten Scaneinheit empfangen werden.

Die erfindungsgemäße MR-System-Kompensationsschnittstelle umfasst außerdem eine Modellermittlungseinheit, welche dazu eingerichtet ist, ein Imperfektionsmodell auf Basis der empfangenen Hardwareparameter bzw. der diesen zugeordneten Hardwareparameterwerte zu ermitteln. Die Modellermittlungseinheit weist für diese Ermittlung jeweils für jede bekannte Imperfektion ein physikalisches Modell auf, das den Ursprung der Imperfektion bzw. die die Imperfektion verursachenden Wirkmechanismen beschreibt. Wie bereits erwähnt, kann durch Anwendung dieses physikalischen Modells auf Basis spezifischer Parameterwerte einer Scaneinheit deren spezifische Abweichung von einem idealen Verhalten ermittelt werden.

Die erfindungsgemäße MR-System-Kompensationsschnittstelle umfasst auch eine Kompensationsmodell-Ermittlungseinheit zum Ermitteln eines Kompensationsmodells auf Basis des Imperfektionsmodells. Ein solches Kompensationsmodell beschreibt für jede Imperfektion jeweils mindestens einen Kompensationsmechanismus, der auf dem jeweiligen Imperfektionsmodell beruht bzw. gerade so ausgebildet ist, dass die durch das betreffende Imperfektionsmodell ermittelte Abweichung durch das Kompensationsmodell aufgehoben bzw. kompensiert wird. Durch das Kompensationsmodell werden Applikationsdaten, die derart modifiziert sind, dass eine Imperfektion der angesteuerten Scaneinheit zumindest teilweise kompensiert wird. Die modifizierten Applikationsdaten umfassen bevorzugt Eingangsdaten für die Scaneinheit des MR-Systems bzw. Ansteuerungsdaten, die so gewählt werden, dass ein gewünschtes Verhalten ohne Imperfektion oder mit reduzierter Imperfektion der Scaneinheit resultiert. Beispielsweise wird bei einer gewünschten Reduktion der Wirbelströme die Form eines Gradienten so verzerrt, dass das resultierende Magnetfeld einen vorbestimmten Verlauf mit reduzierten Wirbelströmen aufweist. Die Kompensation der Wirbelströme kann nicht nur von der Hardware der spezifischen Scaneinheit abhängen, sondern auch von dem Typ der eingesetzten Pulssequenz, die mehr oder weniger anfällig auf Wirbelströme sein kann. Mithin muss auch der Typ der eingesetzten Pulssequenz bei der Kompensation berücksichtigt werden. Die Applikationsdaten können aber auch die Rekonstruktion von Bilddaten umfassen, welche ebenfalls modifiziert werden können, um Imperfektionen einer Scaneinheit zu kompensieren oder zu reduzieren.

Teil der erfindungsgemäßen MR-System-Kompensationsschnittstelle ist auch eine Applikations-Subschnittstelle zum Empfangen von einer Applikation zugeordneten Applikationsdaten. Die Applikations-Subschnittstelle empfängt noch nicht modifizierte Applikationsdaten, vorzugsweise eine konkrete Pulssequenz, die zunächst noch durch die Kompensations-Schnittstelle modifiziert werden muss, bevor sie ausgespielt wird. Die Applikationsdaten, die insbesondere die Pulssequenz umfassen, werden von einer Applikationseinheit empfangen, die die Pulssequenz erzeugt. Die Applikations-Subschnittstelle ist bevorzugt auch dazu eingerichtet, einen Dialog mit einem Bediener zu führen, um eine Pulssequenz und den Ablauf der Bildgebung an individuelle Randbedingungen einer Untersuchung durch Eingabe der bereits erwähnten Steuerparameter anzupassen.

Die Modifikation der Pulssequenz und gegebenenfalls des Ablaufs der Bildgebung bzw. der Applikationsdaten zur Rekonstruktion von Bilddaten erfolgt in einer Kompensationseinheit, die ebenfalls Teil der erfindungsgemäßen MR-System-Kompensationsschnittstelle ist und dazu eingerichtet ist, kompensierte Applikationsdaten, das heißt insbesondere eine modifizierte Pulssequenz und gegebenenfalls auch andere Modifikationen des Ablaufs der Bildgebung auf Basis der empfangenen Applikationsdaten und dem von der Kompensationsmodell-Ermittlungseinheit ermittelten Kompensationsmodell zu erzeugen.

Vorteilhaft wird durch die erfindungsgemäße MR-System-Kompensationsschnittstelle erreicht, dass die eigentliche Applikation so programmiert werden kann, als gäbe es keine Abweichungen einer individuellen Scaneinheit von einem idealen Verhalten. Die Scaneinheit kann also durch die Applikation nach der perfekten "Lehrbuch-Physik" angesteuert werden und die Kompensation selbst wird quasi durch die Scaneinheit und durch die MR-System-Kompensationsschnittstelle gesteuert. Weiterhin erfolgt über die MR-System-Kompensationsschnittstelle ein Dialog zwischen der Applikation und der Scaneinheit, in dem ermittelt wird, welche Imperfektionen zu kompensieren sind und welche der Imperfektionen auch durch die Hardware kompensierbar sind. Gegebenenfalls kann die Applikation auch über die MR-System-Kompensationsschnittstelle beeinflusst werden, sich so zu verhalten, dass eine Kompensation erfolgreich angewendet werden kann. Damit ist gemeint, dass eine erfolgreiche Kompensation auch von den Eingangswerten, die von der Applikation geliefert werden, abhängen kann. Es kann also auch sinnvoll sein, eine Applikation aufzufordern, eine Pulssequenz entsprechend zu modifizieren. Allerdings erfolgt auch bei dieser vorteilhaften Ausgestaltung die Initiative für die Modifizierung der Pulssequenz durch die MR-System-Kompensationsschnittstelle. Vorteilhaft kann eine Applikation also zunächst unabhängig von einer individuellen Hardware programmiert werden, wodurch erhebliche Skaleneffekte und Effektivitätsgewinne erreicht werden.

Anders ausgedrückt können mit der MR-System-Kompensationsschnittstelle unabhängige bzw. gekapselte Applikationen einen gemeinsamen Kompensationsmechanismus nutzen. Diese Vorgehensweise spart sehr viel Zeit und Aufwand bei der Erstellung der Applikationen.

Zudem kann mit einer einzigen Applikationseinheit eine Mehrzahl von technisch möglicherweise gleichartigen oder unterschiedlichen Scaneinheiten, die jeweils die erfindungsgemäße MR-System-Kompensationsschnittstelle aufweisen, angesteuert werden, so dass eine echte Parallelität der Ansteuerung erreicht werden kann. Individuelle Abweichungen von einem durch die Applikation zugrunde gelegten idealen Verhalten werden lokal in den einzelnen MR-System-Kompensationsschnittstellen der einzelnen Scaneinheiten kompensiert.

Die Kompensationsmechanismen sind nun von den eigentlichen Applikationen weg zu dem Scan-Framework hin verlagert. Dadurch müssen die Applikationen selbst viel weniger Informationen über die konkrete Scaneinheit-Hardware besitzen, wodurch sie wiederum unabhängiger von dem konkreten Scaneinheitentyp und anderen Applikationen werden. Außerdem können die Applikationen durch die unabhängige Programmierung viel leichter auf neue Scaneinheitensysteme transferiert werden. Weiterhin können Applikationen und Kompensationsmechanismen voneinander unabhängig weiterentwickelt werden. Dadurch wird die Innovationsgeschwindigkeit erhöht. Wie später noch ausführlich erläutert wird, kann die erfindungsgemäße MR-System-Kompensationsschnittstelle als Hardware-Einheit ausgebildet werden. Eine solche Lösung erlaubt eine besonders hohe Rechengeschwindigkeit, da eine derart ausgestaltete MR-System-Kompensationsschnittstelle auf ihre spezifische Aufgabe hin ausgelegt werden kann. Wird die MR-System-Kompensationsschnittstelle dagegen als Software ausgebildet, so lässt sie sich leichter in bereits bestehende Systeme implementieren, ohne aufwändige Ergänzung durch zusätzliche Hardware.

Die erfindungsgemäße MR-System-Steuereinrichtung weist eine als Applikationserzeugungseinheit wirkende Applikationseinheit, eine bevorzugt universelle Scaneinheit-Schnittstelle und eine erfindungsgemäße MR-System-Kompensationsschnittstelle auf. Wie bereits erwähnt, erzeugt eine Applikationseinheit die Applikation und führt sie im Rahmen eines Bildgebungsprozesses durch. Dabei werden gegebenenfalls von einem Benutzer eingegebene Steuerdaten bzw. Steuerparameter berücksichtigt. Weiterhin ist Teil der Applikation auch die nach dem Empfang von Magnetresonanzsignalen auf deren Basis bzw. auf Basis der daraus resultierenden Rohdaten durchgeführte Rekonstruktion von Bilddaten. Ist die Scaneinheit-Schnittstelle als universelle Scaneinheit-Schnittstelle ausgestaltet, so wird es dadurch ermöglicht, Applikationen so zu standardisieren, dass sie mit jeder Scaneinheit, die eine solche Scaneinheit-Schnittstelle aufweist, ohne Änderung oder Anpassung verwendet werden kann. Im Zusammenhang mit der universellen Scaneinheit-Schnittstelle wird nochmals ausdrücklich auf die europäische Patentanmeldung mit dem amtlichen Aktenzeichen 2021 6753 Bezug genommen, die eine solche universelle Scaneinheit-Schnittstelle beschreibt und hiermit vollständig in die vorliegende Patentanmeldung mit einbezogen ist. Die erfindungsgemäße MR-System-Kompensationsschnittstelle bewirkt eine Modifikation der Ansteuerung bzw. einer auf Basis der Pulssequenz erzeugten Ansteuersequenz in Abhängigkeit von individuellen Abweichungen der jeweiligen Scaneinheit von einem idealen Verhalten. Die erfindungsgemäße MR-System-Kompensationsschnittstelle kann als Teil der universellen Scaneinheit-Schnittstelle bzw. seriell mit dieser, aber auch parallel zu der Scaneinheit-Schnittstelle ausgebildet sein.

Ist die MR-System-Kompensationsschnittstelle zu der Scaneinheit-Schnittstelle parallel ausgebildet, so kann die Scaneinheit-Schnittstelle, bevorzugt als universelle Scaneinheit-Schnittstelle wie gewohnt ohne Korrektur bzw. Kompensation von Imperfektionen oder durch Applikationen mit integrierter Korrektur von Imperfektionen genutzt werden. Alternativ kann die MR-System-Kompensationsschnittstelle genutzt werden, wenn Applikationen genutzt werden sollen, die keine integrierte Korrektur der Imperfektionen aufweisen und durch eine Korrektur von Imperfektionen eine Verbesserung der Bildqualität zu erwarten ist. Die MR-System-Kompensationsschnittstelle kann in diesem Fall vorteilhaft von einer Vielzahl von unterschiedlichen Applikationen gemeinsam genutzt werden. Ist die MR-System-Kompensationsschnittstelle als Teil der Scaneinheit-Schnittstelle bzw. seriell mit dieser ausgebildet, so erfolgt in jedem Fall eine Zwischenschaltung der Funktion der MR-System-Kompensationsschnittstelle. Die MR-System-Kompensationsschnittstelle ermöglicht eine Abstraktion einer Applikation von einem imperfekten Verhalten einer Scaneinheit. Die erfindungsgemäße MR-System-Steuereinrichtung teilt die Vorteile der erfindungsgemäßen MR-System-Kompensationsschnittstelle.

Das erfindungsgemäße Magnetresonanzbildgebungssystem umfasst eine erfindungsgemäße MR-Steuereinrichtung und eine Scaneinheit. Das erfindungsgemäße Magnetresonanzbildgebungssystem teilt die Vorteile der erfindungsgemäßen MR-System-Kompensationsschnittstelle.

Bei dem erfindungsgemäßen Verfahren zum Ermitteln einer Ansteuersequenz eines Magnetresonanzbildgebungssystems zur Erzeugung von Magnetresonanzbilddaten eines Untersuchungsobjekts werden individuelle Hardwareparameter von einer individuellen Scaneinheit eines MR-Systems durch eine Hardware-Subschnittstelle empfangen. Auf Basis der individuellen bzw. spezifischen Hardwareparameter wird ein Imperfektionsmodell ermittelt. Auf Basis des Imperfektionsmodells wird dann ein Kompensationsmodell ermittelt. Weiterhin werden einer Applikation zugeordnete Applikationsdaten von einer Applikationseinheit empfangen. Auf Basis der empfangenen Applikationsdaten und dem ermittelten Kompensationsmodell werden kompensierte Applikationsdaten ermittelt. Diese kompensierten Applikationsdaten werden dann an die individuelle Scaneinheit übermittelt und weisen an die individuelle Scaneinheit angepasste Eigenschaften auf, um deren Abweichung von einem idealen Verhalten zu kompensieren. Die kompensierten Applikationsdaten können im Anschluss zur Ansteuerung der Scaneinheit sowie auch zur Rekonstruktion von Bilddaten auf Basis von im Rahmen der Ausführung der Applikation erfassten Rohdaten genutzt werden. Das erfindungsgemäße Verfahren teilt die Vorteile der erfindungsgemäßen MR-System-Kompensationsschnittstelle.

Einige Komponenten der erfindungsgemäßen MR-System-Kompensationsschnittstelle können zum überwiegenden Teil in Form von Softwarekomponenten ausgebildet sein. Dies betrifft insbesondere Teile der Modellermittlungseinheit, der Kompensationsmodell-Ermittlungseinheit und der Kompensationseinheit.

Grundsätzlich können diese Komponenten aber auch zum Teil, insbesondere wenn es um besonders schnelle Berechnungen geht, in Form von softwareunterstützter Hardware, beispielsweise FPGAs, durch Anwendung von Prozessoren oder dergleichen, realisiert sein. Ebenso können die benötigten Schnittstellen, wie zum Beispiel die Hardware-Subschnittstelle und die Applikations-Subschnittstelle, beispielsweise wenn es nur um eine Übernahme von Daten aus anderen Softwarekomponenten geht, als Softwareschnittstellen ausgebildet sein. Sie können aber auch als hardwaremäßig aufgebaute Schnittstellen, die durch geeignete Software angesteuert werden, ausgebildet sein.

Eine weitgehend softwaremäßige Realisierung hat den Vorteil, dass auch schon bisher in einem Magnetresonanzbildgebungssystem vorhandene Rechnersysteme nach einer eventuellen Ergänzung durch zusätzliche Hardwareelemente auf einfache Weise durch ein Software-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in eine Speichereinrichtung eines solchen Magnetresonanzbildgebungssystems ladbar ist, mit Programmabschnitten, um die durch Software realisierbaren Schritte des erfindungsgemäßen Verfahrens auszuführen, wenn das Computerprogramm in dem Magnetresonanzbildgebungssystem ausgeführt wird.

Ein solches Computerprogrammprodukt kann neben dem Computerprogramm gegebenenfalls zusätzliche Bestandteile, wie z.B. eine Dokumentation und/oder zusätzliche Komponenten, auch Hardware-Komponenten, wie z.B. Hardware-Schlüssel (Dongles etc.) zur Nutzung der Software, umfassen.

Zum Transport zur Speichereinrichtung einer Rechnereinheit eines Magnetresonanzbildgebungssystems und/oder zur Speicherung an der Rechnereinheit kann ein computerlesbares Medium, beispielsweise ein Memorystick, eine Festplatte oder ein sonstiger transportabler oder fest eingebauter Datenträger dienen, auf welchem die von einer Rechnereinheit einlesbaren und ausführbaren Programmabschnitte des Computerprogramms gespeichert sind. Die Rechnereinheit kann z. B. hierzu einen
oder mehrere zusammenarbeitende Mikroprozessoren oder dergleichen aufweisen.

Die abhängigen Ansprüche sowie die nachfolgende Beschreibung enthalten jeweils besonders vorteilhafte Ausgestaltungen und Weiterbildungen der Erfindung. Dabei können insbesondere die Ansprüche einer Anspruchskategorie auch analog zu den abhängigen Ansprüchen einer anderen Anspruchskategorie und deren Beschreibungsteilen weitergebildet sein. Zudem können im Rahmen der Erfindung die verschiedenen Merkmale unterschiedlicher Ausführungsbeispiele und Ansprüche auch zu neuen Ausführungsbeispielen kombiniert werden.

In einer Ausgestaltung der erfindungsgemäßen MR-System-Kompensationsschnittstelle ist die Kompensationsmodell-Ermittlungseinheit dazu eingerichtet, durch die Applikationsdaten festgelegte Werte für zeitliche Abfolgen und zeitliche Abstände einer Pulssequenz der Applikation unverändert aufrechtzuerhalten. Dies ist wichtig, da sich zur Aufrechterhaltung der Bildqualität bzw. des Bildkontrasts der zeitliche Abstand zwischen einem HF-Puls und einem Gradienten im Normalfall nicht verändern darf. Ebenso wenig darf sich in der Regel die zeitliche Länge eines HF-Pulses oder Gradienten ändern.

Vorzugsweise umfasst das Imperfektionsmodell der erfindungsgemäßen MR-System-Kompensationsschnittstelle mindestens eines der folgenden Modelltypen:
- ein physikalisches Modell
- ein trainiertes Modell.

Ein physikalisches Modell kann in vielen Fällen physikalische Effekte, welche zu einer Abweichung von einem idealen bzw. universellen physikalischen Modell einer MR-Scaneinheit führen, exakt beschreiben. Zur Anpassung des physikalischen Modells an eine individuelle Scaneinheit müssen im einfachsten Fall lediglich Hardwareparameter erfasst werden. Mithin ist der Aufwand für eine Anpassung des physikalischen Modells an eine konkrete Hardware relativ gering.

Anstatt eines starren physikalischen Modells kann auch ein trainiertes Modell, beispielsweise umfassend ein oder mehrere künstliche neuronale Netze, zur Ermittlung der Abweichungen in einer Scaneinheit von einem idealen bzw. universellen physikalischen Modell genutzt werden. Die künstlichen neuronalen Netze übernehmen dabei entweder die Rolle einer gesamtheitlichen Beschreibung aller zu Abweichungen beitragenden physikalischen Effekte oder jeweils nur eines einzelnen solchen Effekts. Im letzteren Fall führt dann eine Zusammenschaltung einzelner künstlicher neuronaler Netze zu einer Gesamtheit, die alle für die Messung relevanten Imperfektionen simuliert. Vorteilhaft lassen sich trainierte Modelle auch an Systeme anpassen, die nicht vollständig durch "starre Modelle", wie zum Beispiel physikalische Modelle verstanden sind. Trainierte Modelle sind auch sehr flexibel an unterschiedliche Randbedingungen anpassbar.

Bevorzugt umfasst das Imperfektionsmodell eine Mehrzahl von trainierten Modellen, die jeweils einem unterschiedlichen physikalischen Effekt zugeordnet sind. Vorteilhaft kann die Simulation einzelner Abweichungen trainiert werden. Dabei können Probleme bei der Nachbildung der physikalischen Effekte durch die trainierten Modelle leichter erkannt werden.

Ganz besonders bevorzugt umfasst das Imperfektionsmodell ein einziges trainiertes Modell. Diese Variante reduziert den Aufwand des Trainings des Modells, da nur ein einziges Modell trainiert werden muss.

In einer Variante der erfindungsgemäßen MR-System-Kompensationsschnittstelle weist das Kompensationsmodell zu einer bestimmten Imperfektion eine Mehrzahl von Kompensations-Algorithmen auf und die Kompensationseinheit ist dazu eingerichtet, auf Basis der Applikationsdaten einen der KompensationsAlgorithmen auszuwählen. Beispielsweise kann für eine erste Applikation ein erstes Kompensationsmodell ausgewählt werden und für eine zweite Applikation, welche sich vom Typ her von der ersten Applikation unterscheidet, ein zweites Kompensationsmodell ausgewählt werden. Vorteilhaft kann ein Kompensationsprozess trotz der Universalität der MR-System-Kompensationsschnittstelle auch durch Auswahl eines Kompensations-Algorithmus an eine spezifische Applikation angepasst werden.

Die Kompensationsmodell-Ermittlungseinheit der erfindungsgemäßen MR-System-Kompensationsschnittstelle ist also bevorzugt dazu eingerichtet, das Kompensationsmodell unter mehreren Modellen auf Basis der Applikationsdaten zu ermitteln. Bei der Imperfektion Wirbelströme erfordern zum Beispiel einige Applikationen, dass das ausgespielte Gradientenmoment möglichst getreu ist, zum Beispiel bei radialem Auslesen. Andere Applikationen stellen die Anforderung, dass nach einem Gradienten keine Wirbelströme verbleiben, z.B. bei diffusionsgewichteter Bildgebung. Beide Anforderungen sind nicht gleichzeitig in vollem Umfang erreichbar. Eine spezifische Applikation kann also vorgeben, was wichtiger ist. Das geeignetste Modell kann dann auf Basis des spezifischen Typs der Applikation ausgewählt werden. Falls nur ein einziges solches Modell vorhanden ist, kann dieses auch auf Basis der spezifischen Applikation angepasst werden. Vorteilhaft wird eine Kompensation an eine individuelle Anwendung angepasst und trotzdem die Universalität der Kompensations-Schnittstelle und die universelle Anwendbarkeit der Applikation aufrechterhalten.

Die Kompensationsmodell-Ermittlungseinheit der erfindungsgemäßen MR-System-Kompensationsschnittstelle kann dazu eingerichtet sein, das Kompensationsmodell in Abhängigkeit von den Kompensationsmitteln der Hardware und/oder in Abhängigkeit von Software-Lizenzen zu ermitteln. Bei der Imperfektion Wirbelströme können alle Typen von Scanheiten eine Korrektur durch die Vorverzerrung der Gradientenpulse durchführen. Scaneinheiten mit einer Shim-Spule höherer Ordnung können zusätzlich diese benutzen, um Wirbelströme zu unterdrücken bzw. zu reduzieren. Dadurch lassen sich alle durch die Hardware oder Software zur Verfügung stehenden Möglichkeiten zur Kompensation von Imperfektionen nutzen.

In einer Ausgestaltung der erfindungsgemäßen MR-System-Kompensationsschnittstelle ist die Applikations-Subschnittstelle als Dialogschnittstelle dazu ausgebildet, der Applikation mitzuteilen, welcher Kompensations-Algorithmus verfügbar ist und welche Option auswählbar ist bzw. welche auswählbare Option die jeweiligen Kompensations-Algorithmen gegebenenfalls aufweisen. Eine solche Dialogschnittstelle kann technische Mittel zum Datenaustausch mit der Applikation oder zur Anzeige oder Angabe von verfügbaren Kompensationsalgorithmen und technische Mittel zur Eingabe bzw. Auswahl eines der verfügbaren Kompensationsalgorithmen aufweisen. Solche technischen Mittel können zum Beispiel Mittel zum automatisierten Anzeigen, akustische Mitteilungseinheiten, Dialogfelder und Eingabefelder auf Anzeigen, akustische Eingabeeinheiten und ähnliches umfassen. Vorteilhaft kann ein Bediener seine individuellen Kenntnisse und Anforderungen an eine Kompensation von Imperfektionen in die Wahl eines geeigneten Kompensationsalgorithmus einfließen lassen. Außerdem kann die Dialogschnittstelle so ausgestaltet sein, dass eine Applikation dazu in die Lage versetzt wird, selbst auf Basis der über die Dialogschnittstelle erhaltenen Informationen gegebenenfalls unter mehreren Kompensations-Algorithmen einen geeigneten Kompensations-Algorithmus, der für die spezifische Applikation entsprechend geeignet ist, automatisiert auswählen.

Die erfindungsgemäße MR-System-Kompensationsschnittstelle kann auch als Softwareversion ausgebildet sein. Dadurch können im Laufe der Zeit sowohl die Kompensationsmechanismen als auch die Applikationen unabhängig voneinander weiterentwickelt werden.

Ein Vorteil einer solchen Versionierung besteht darin, dass bei einer Weiterentwicklung der Kompensationsmechanismen oder der Applikationen die "alte Version" der Schnittstelle weiterhin zur Verfügung stehen kann, so dass die alten Applikationen weitergenutzt werden können und kein kompletter Austausch der Applikationen erforderlich ist.

Die erfindungsgemäße MR-System-Kompensationsschnittstelle und hier insbesondere die Kompensationseinheit der erfindungsgemäße MR-System-Kompensationsschnittstelle kann in einer alternativen Variante im Gegensatz zu dem vorstehend genannten auch dazu ausgebildet sein, die zeitliche Abfolge und/oder Dauer einer von den Applikationsdaten umfassten Applikation, bevorzugt die zeitliche Abfolge und/oder Dauer von Gradienten und Anregungspulsen der betreffenden Pulssequenz der Applikation, zu ändern. Häufig sind dabei weitere Anpassungen notwendig, damit der erzielte physikalische Effekt nicht verändert wird. Beispielsweise kann ein Anregungspuls zeitlich verkürzt werden, wenn die Amplitude des Anregungspulses und die Amplitude des gleichzeitig ausgespielten Schichtselektionspulses erhöht werden. Durch diese Änderung wird der Puls robuster gegen B0-Inhomogenitäten gemacht. Wenn die Verkürzung symmetrisch um die zeitliche Mitte des Pulses geschieht, dann gibt es keinen Einfluss auf den Kontrast des resultierenden Bildes. Vorteilhaft lässt sich also in bestimmten Spezialfällen die Beschränkung der Beibehaltung der zeitlichen Abfolge und/oder Dauer einer Applikation aufheben.

Die erfindungsgemäße MR-System-Kompensationsschnittstelle kann dazu eingerichtet sein, in Abhängigkeit von dem ermittelten Kompensationsmodell einen Dialog zwischen einer Bedienperson und einer vorzugsweise universellen Scaneinheit-Schnittstelle zu gestalten. Generell stellt die vorzugsweise universelle Scaneinheit-Schnittstelle der Applikation Informationen zur Verfügung, die zur Planung der Sequenz wichtig sind. Diese sind zum Beispiel technisch bedingte Grenzen von HF-Pulsen und Gradienten, Grenzen für maximale Amplituden, "slew rates" bzw. Steigungen von Gradienten und Grenzen für ein maximales B1-Feld bzw. Gradientenfeld. Diese die Hardware betreffenden Limitierungen müssen bei der Erzeugung einer Pulssequenz und deren Modifikation zur Kompensation individueller Imperfektionen der Scaneinheit eingehalten werden.

Die Benutzung eines Kompensationsmechanismus kann erfordern, dass die bevorzugt universelle Scaneinheit-Schnittstelle andere Informationen zur Verfügung stellt als ohne die Benutzung des Kompensationsmechanismus. Diese Informationen können insbesondere die Limitierung von Sequenzparametern bzw. von physikalischen Größen der ausgespielten Pulse betreffen. Wenn beispielsweise mit einem Kompensationsmechanismus Gradienten ausgespielt werden, dann muss verhindert werden, dass die Summe der Gradienten von Applikation und Kompensationsmechanismus in Summe die Möglichkeiten bzw. technischen Limitierungen der Scaneinheit überschreiten. Bei der Imperfektion Wirbelströme benötigt die Kompensation, d.h. die Vorverzerrung der Gradientenpulse, Werte von etwa 5 mT/m. Wenn das Gradientensystem Gradienten mit maximal 45 mT/m liefern kann, dann gibt die Scaneinheit-Schnittstelle einen Wert von 40 mT/s als Maximalwert an die Applikation, falls die Kompensation aktiv ist und 45 mT/s, falls die Kompensation nicht aktiv ist.

Die Kompensationseinheit der erfindungsgemäßen KompensationsSchnittstelle kann dazu eingerichtet sein, auf Basis der individuellen Hardwareparameter und des Imperfektionsmodells zu ermitteln, welche Qualität die Kompensation durch das Kompensationsmodell aufweisen wird. Diese Information kann von der Applikation genutzt werden, um die Sequenz und Rekonstruktion anzupassen. Beispielsweise löst die Vorhersage von verbleibenden Phasenfehlern nach der Kompensation von Wirbelströmen die Entscheidung innerhalb der Sequenz aus, ob ein Phasenkorrekturscan aufgenommen wird. Vorteilhaft wird auf diese Weise ein verbesserter Bildkontrast erreicht.

Die Erfindung wird im Folgenden unter Hinweis auf die beigefügten Figuren anhand von Ausführungsbeispielen noch einmal näher erläutert. Es zeigen:
FIG 1 eine schematische Darstellung eines herkömmlichen Magnetresonanzbildgebungssystems,
FIG 2 eine schematische Darstellung eines Magnetresonanzbildgebungssystems mit einer MR-System-Kompensationsschnittstelle gemäß einem Ausführungsbeispiel der Erfindung,
FIG 3 eine detailliertere schematische Darstellung eines Magnetresonanzbildgebungssystems mit einer MR-System-Kompensationsschnittstelle gemäß einem Ausführungsbeispiel der Erfindung,
FIG 4 eine schematische Darstellung eines Magnetresonanzbildgebungssystems gemäß einem Ausführungsbeispiel der Erfindung mit einer detaillierten Darstellung einer MR-System-Steuereinrichtung gemäß einem Ausführungsbeispiel der Erfindung,
FIG 5 ein Flussdiagramm zur Veranschaulichung eines Verfahrens zum Ermitteln einer Ansteuersequenz eines Magnetresonanzbildgebungssystems zur Erzeugung von Magnetresonanzbilddaten eines Untersuchungsobjekts gemäß einem Ausführungsbeispiel der Erfindung.

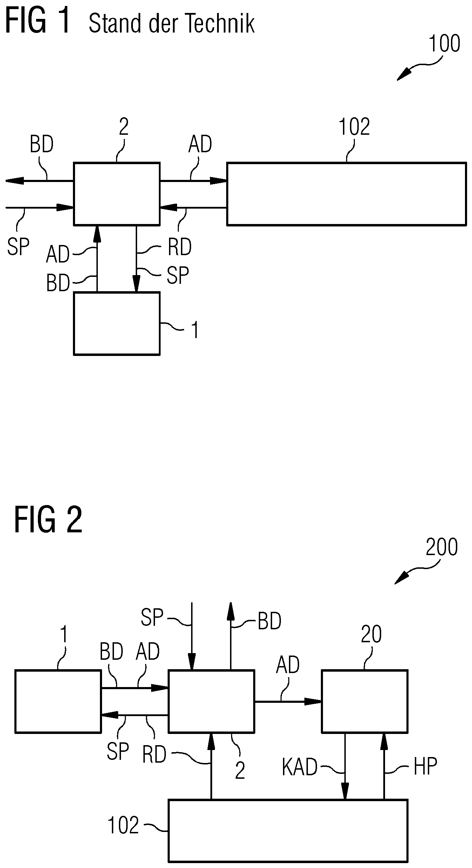

In FIG 1 ist eine schematische Darstellung eines herkömmlichen Magnetresonanzbildgebungssystems 100 gezeigt. Das Magnetresonanzbildgebungssystem 100 umfasst eine Applikationseinheit 1, die speziell für eine bestimmte Scaneinheit 102 programmiert ist. Durch die Applikationseinheit 1 werden Applikationsdaten AD erzeugt, die eine spezifische Pulssequenz umfassen. Die Applikationsdaten AD werden über eine Scaneinheit-Schnittstelle 2 an eine Scaneinheit 102 übermittelt. Dort werden Gradientensignale und HF-Signale über ein Spulensystem auf ein Untersuchungsobjekt appliziert und es werden Messsignale von dem Untersuchungsobjekt erfasst. Auf Basis von durch die Messsignale gebildeten Rohdaten RD werden schließlich von der Applikationseinheit 1 Bilddaten BD rekonstruiert und über die universelle Scaneinheit-Schnittstelle 2 an einen Benutzer ausgegeben. Weiterhin können über die universelle Scaneinheit-Schnittstelle 2 spezifizierende Steuerparameter SP durch den Benutzer eingegeben werden, um die Applikationsdaten AD an spezifische Anforderungen, beispielsweise individuelle Patientendaten, anzupassen.

In FIG 2 ist ein Magnetresonanzbildgebungssystem 200 gemäß einem Ausführungsbeispiel der Erfindung veranschaulicht. Ähnlich wie das herkömmliche Magnetresonanzbildgebungssystem 100 umfasst das Magnetresonanzbildgebungssystem 200 gemäß einem Ausführungsbeispiel der Erfindung eine Applikations-Einheit 1, mit der eine Applikation für die Bildgebung eines Untersuchungsobjekts erzeugt wird. Die Applikationsdaten AD werden über eine universelle Scaneinheit-Schnittstelle 2 an eine MR-System-Kompensationsschnittstelle 20 gemäß einem Ausführungsbeispiel der Erfindung übertragen. Außerdem können über die universelle Scaneinheit-Schnittstelle 2 vorab spezifizierende Steuerparameter SP durch den Benutzer eingegeben werden, um die Applikationsdaten AD an spezifische Anforderungen anzupassen.

Die MR-System-Kompensationsschnittstelle 20 modifiziert die Applikationsdaten AD. Hierzu empfängt sie Hardwareparameter bzw. entsprechende Hardwareparameterwerte HP von einer Scaneinheit 102 des Magnetresonanzbildgebungssystems 200. Auf deren Basis werden kompensierte Applikationsdaten KAD erzeugt, auf deren Basis von der Scaneinheit 102 über ein Spulensystem Gradientensignale und HF-Signale auf einen Untersuchungsbereich eines Untersuchungsobjekts appliziert werden. Auf Basis der von dem Spulensystem erfassten Messsignale bzw. auf Basis von durch diese Messsignale gebildeten Rohdaten RD werden dann durch die Applikationseinheit 1 Bilddaten BD von dem Untersuchungsbereich rekonstruiert und über die universelle Scaneinheit-Schnittstelle 2 an einen Benutzer ausgegeben.

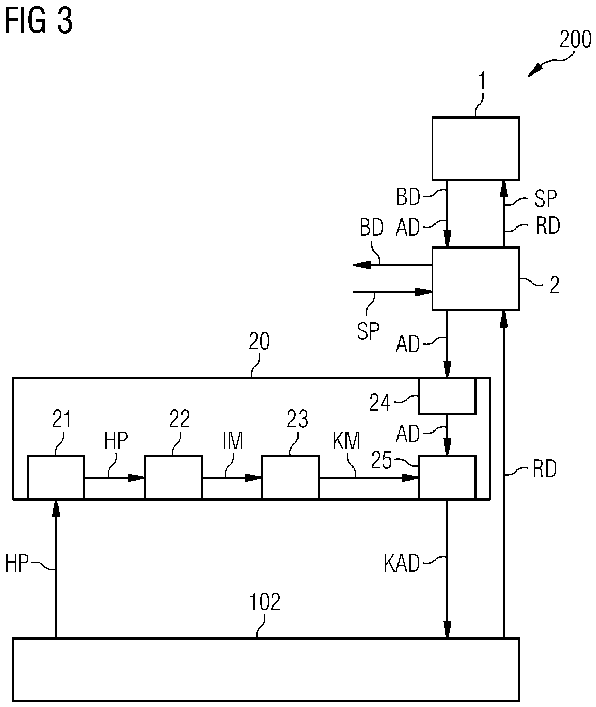

In FIG 3 ist eine detailliertere schematische Darstellung eines Magnetresonanzbildgebungssystems 200 mit einer MR-System-Kompensationsschnittstelle 20 gemäß einem Ausführungsbeispiel der Erfindung veranschaulicht. Das Magnetresonanzbildgebungssystem 100 zeigt neben der MR-System-Kompensationsschnittstelle 20 auch die bereits in FIG 2 veranschaulichten Funktionselemente einer Applikation 1, einer universellen Scaneinheit-Schnittstelle 2 und der Scaneinheit 102 selbst. Wie bereits erwähnt, kann über die universelle Scaneinheit-Schnittstelle 2 eine Kommunikation durch Eingabe von Steuerparametern SP zwischen dem Benutzer und der Applikation 1 sowie durch Übermitteln von Applikationsdaten AD zwischen der Applikation und der MR-System-Kompensationsschnittstelle 20 erfolgen.

Die MR-System-Kompensationsschnittstelle 20 umfasst eine Hardware-Subschnittstelle 21, mit der Hardwareparameterwerte HP von der Scaneinheit 102 des Magnetresonanzbildgebungssystems 200 empfangen werden. Diese Hardwareparameterwerte HP werden von einer Modellermittlungseinheit 22, die ebenfalls Teil der MR-System-Kompensationsschnittstelle 20 ist, dazu genutzt, ein Imperfektionsmodell IM zu ermitteln und zu spezifizieren. Das ermittelte und spezifizierte Imperfektionsmodell IM wird an eine Kompensationsmodell-Ermittlungseinheit 23, die auf Basis des Imperfektionsmodells IM ein Kompensationsmodell KM erzeugt, übermittelt. Außerdem werden Applikationsdaten AD von der MR-System-Kompensationsschnittstelle 20 über eine von der MR-System-Kompensationsschnittstelle 20 ebenfalls umfasste Applikations-Subschnittstelle 24 empfangen. Auf Basis der empfangenen Applikationsdaten AD und des Kompensationsmodells KM von der Kompensationsmodell-Ermittlungseinheit 23 werden durch die Kompensationseinheit 25 kompensierte Applikationsdaten KAD erzeugt und an die Scaneinheit 102 übermittelt. Auf deren Basis werden von der ScanEinheit 102 über ein Spulensystem Gradientensignale und HF-Signale auf einen Untersuchungsbereich eines Untersuchungsobjekts appliziert. Auf Basis der von dem Spulensystem erfassten Messsignale bzw. durch diese Messsignale gebildete Rohdaten RD werden dann durch die Applikationseinheit 1 Bilddaten BD von dem Untersuchungsbereich rekonstruiert und über die universelle Scaneinheit-Schnittstelle 2 an einen Benutzer ausgegeben. Es soll an dieser Stelle darauf hingewiesen werden, dass nicht nur kompensierte Applikationsdaten zur Ansteuerung der Scaneinheit erzeugt werden können, sondern es können auch Funktionalitäten bzw. Algorithmen der Applikation, welche zur Rekonstruktion von Bilddaten BD genutzt werden, derart modifiziert werden, dass die Rekonstruktion an Imperfektionen der Scaneinheit angepasst wird.

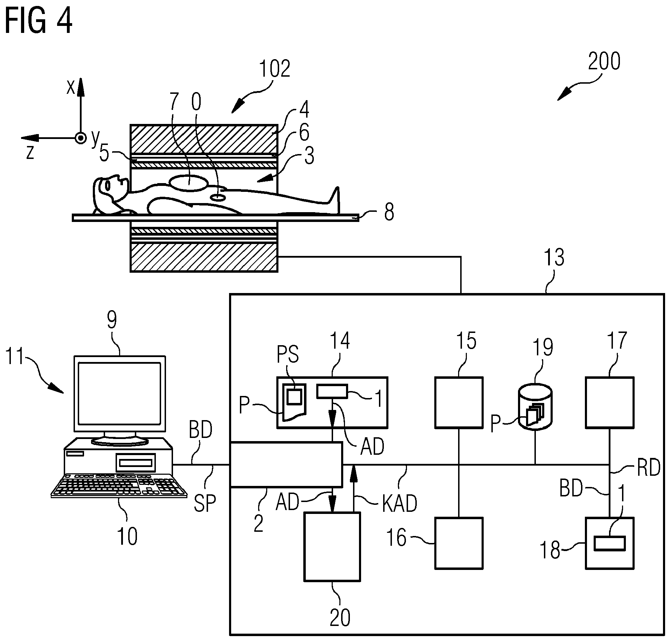

In FIG 4 ist grob schematisch ein erfindungsgemäßes Magnetresonanzbildgebungssystem 200 (im Folgenden kurz "MR-System" genannt) dargestellt. Es umfasst zum einen die eigentliche Scaneinheit 102 mit einem Untersuchungsraum 3 bzw. Patiententunnel, in den auf einer Liege 8 ein Patient O oder Proband, in dessen Körper sich beispielsweise ein bestimmtes abzubildendes Organ befindet, eingefahren werden kann.

Die Scaneinheit 102 ist in üblicher Weise mit einem Grundfeldmagnetsystem 4, einem Gradientensystem 6 sowie einem HF-Sendeantennensystem 5 und einem HF-Empfangsantennensystem 7 ausgestattet. In dem dargestellten Ausführungsbeispiel handelt es sich bei dem HF-Sendeantennensystemen 5 um eine in der Scaneinheit 102 fest eingebaute Ganzkörperspule, wogegen das HF-Empfangsantennensystem 7 aus am Patienten bzw. Probanden anzuordnenden Lokalspulen besteht (in FIG 4 nur durch eine einzelne Lokalspule symbolisiert). Grundsätzlich kann aber auch die Ganzkörperspule 5 als HF-Empfangsantennensystem genutzt werden und die Lokalspulen 7 als HF-Sendeantennensystem, sofern diese Spulen jeweils in unterschiedliche Betriebsweisen umschaltbar sind.

Das MR-System 200 weist weiterhin als erfindungsgemäße MR-System-Steuereinrichtung eine zentrale Steuereinrichtung 13 auf, die zur Steuerung des MR-Systems 200 verwendet wird. Diese zentrale Steuereinrichtung 13 umfasst eine Sequenzsteuereinheit 14 zur Pulssequenzsteuerung. Mit dieser wird die zeitliche Abfolge von Hochfrequenz-Pulsen (HF-Pulsen) und von Gradientenpulsen in Abhängigkeit von einer gewählten Bildgebungssequenz PS gesteuert. Eine solche Bildgebungssequenz PS kann beispielsweise innerhalb eines Mess- oder Steuerprotokolls P vorgegeben sein. Üblicherweise sind verschiedene Steuerprotokolle P für unterschiedliche Messungen in einem Speicher 19 hinterlegt und können von einem Bediener ausgewählt (und bei Bedarf gegebenenfalls geändert) und dann zur Durchführung der Messung genutzt werden. Die Sequenzsteuereinheit 14 umfasst die Funktion der in FIG 2 und FIG 3 veranschaulichten Applikationseinheit 1 zum Erzeugen und Ausspielen einer Bildgebungssequenz PS in Form von Applikationsdaten AD.

Die zentrale Steuereinrichtung 13 umfasst auch eine erfindungsgemäße MR-System-Kompensationsschnittstelle 20, die den in FIG 3 gezeigten Aufbau aufweist. Die MR-System-Kompensationsschnittstelle 20 erzeugt auf Basis der von der Sequenzsteuereinheit 14 ausgegebenen Applikationsdaten AD kompensierte Applikationsdaten KAD, mit denen die im Folgenden kurz beschriebenen Funktionseinheiten angesteuert werden.

Zur Ausgabe der einzelnen HF-Pulse weist die zentrale Steuereinrichtung 13 eine Hochfrequenzsendeeinrichtung 15 auf, die die HF-Pulse erzeugt, verstärkt und über eine geeignete Schnittstelle (nicht im Detail dargestellt) in das HF-Sendeantennensystem 5 einspeist. Zur Steuerung der Gradientenspulen des Gradientensystems 6 weist die Steuereinrichtung 13 eine Gradientensystemschnittstelle 16 auf. Die Sequenzsteuereinheit 14 kommuniziert in geeigneter Weise, z. B. durch Aussendung von anschließend durch die MR-System-Kompensationsschnittstelle 20 kompensierten Applikationsdaten KAD, mit der Hochfrequenzsendeeinrichtung 15 und der Gradientensystemschnittstelle 16 zur Aussendung der Pulssequenzen PS in der durch die MR-System-Kompensationsschnittstelle 20 erzeugten kompensierten Form. Die zentrale Steuereinrichtung 13 weist außerdem eine (ebenfalls in geeigneter Weise mit der Sequenzsteuereinheit 14 kommunizierende) Hochfrequenzempfangseinrichtung 17 auf, um koordiniert vom HF-Sendeantennensystem 7 empfangene Magnetresonanz-Signale zu akquirieren. Eine Rekonstruktionseinheit 18, die ebenfalls eine Funktion der in FIG 2 und FIG 3 dargestellten Applikationseinheit 1 wahrnimmt, übernimmt die akquirierten Daten nach Demodulierung und Digitalisierung als Rohdaten RD und rekonstruiert daraus MR-Bilddaten BD. Auch die Rekonstruktion der Bilddaten kann auf Basis von modifizierten bzw. kompensierten Applikationsdaten KAD erfolgen. Dadurch können zum Beispiel durch eine Imperfektion erzeugten Bildartefakte im Nachhinein reduziert oder gar eliminiert werden. Diese Bilddaten BD können dann beispielsweise in einem Speicher 19 hinterlegt werden.

Eine Bedienung der zentralen Steuereinrichtung 13 kann über ein Terminal 11 mit einer Eingabeeinheit 10 und einer Anzeigeeinheit 9, über das somit auch das gesamte MR-System 200 durch eine Bedienperson bedient werden kann, erfolgen. Auf der Anzeigeeinheit 9 können auch MR-Bilder angezeigt werden, und mittels der Eingabeeinheit 10 ggf. in Kombination mit der Anzeigeeinheit 9 können Messungen geplant und gestartet und insbesondere geeignete Steuerprotokolle mit geeigneten Messsequenzen wie oben erläutert ausgewählt und gegebenenfalls modifiziert werden.

Eine Kommunikation zwischen dem Terminal 11 und der zentralen Steuereinrichtung 13 sowie zwischen der Applikation und der MR-System-Kompensationsschnittstelle 20 erfolgt über eine universelle Hardware-Schnittstelle 2. Beispielsweise können über das Terminal und die universelle Hardware-Schnittstelle 2 Steuerparameter SP an die zentrale Steuereinrichtung 13 übermittelt werden, die in der Sequenzsteuereinheit 14 zur Erzeugung einer Pulssequenz bzw. darauf basierenden Steuerdaten bzw. Applikationsdaten AD genutzt wird.

Die erfindungsgemäße MR-Anlage 200 und insbesondere die zentrale Steuereinrichtung 13 können darüber hinaus noch eine Vielzahl von weiteren, hier nicht im Einzelnen dargestellten, aber üblicherweise an solchen Geräten vorhandenen Komponenten aufweisen, wie beispielsweise eine Netzwerkschnittstelle, um die gesamte Anlage mit einem Netzwerk zu verbinden und Rohdaten RD und/oder Bilddaten BD bzw. Parameterkarten, aber auch weitere Daten, wie beispielsweise patientenrelevante Daten oder Steuerprotokolle, austauschen zu können.

Wie durch ein Einstrahlen von HF-Pulsen und die Erzeugung von Gradientenfeldern geeignete Rohdaten RD akquiriert und daraus MR-Bilder BD rekonstruiert werden können, ist dem Fachmann grundsätzlich bekannt und wird hier nicht näher erläutert. Ebenso sind verschiedenste Messsequenzen, wie zum Beispiel Spin-Echo-Sequenzen, EPI-Sequenzen (EPI = Echo-Planar-Bildgebung), GRE-Messsequenzen (GRE = Gradientenecho) oder TSE-Messsequenzen (TSE = Turbo-Spin-Echo) zur Erzeugung von dynamischen oder statischen Abbildungen, dem Fachmann vom Grundsatz her bekannt.

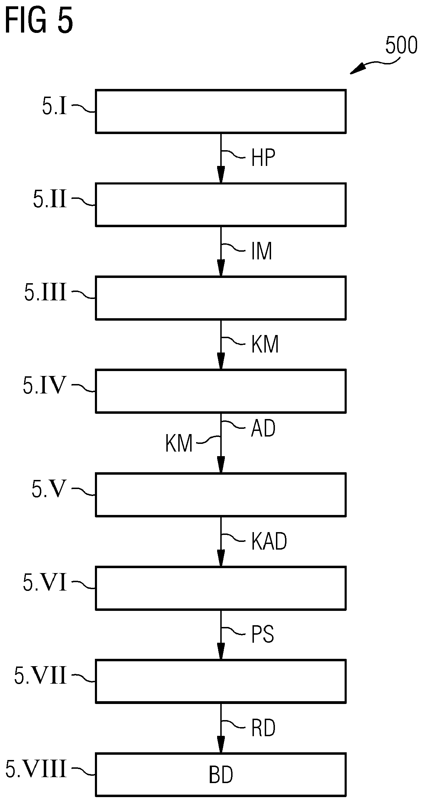

In FIG 5 ist ein Flussdiagramm 500 gezeigt, welches ein Verfahren zum Ermitteln einer Ansteuersequenz eines Magnetresonanzbildgebungssystems zur Erzeugung von Magnetresonanzbilddaten eines Untersuchungsobjekts veranschaulicht.

Bei dem Schritt 5.I werden individuelle Hardwareparameter HP von einer individuellen Scaneinheit eines MR-Systems empfangen. Solche Hardwareparameter HP geben Auskunft über konkrete technisch/physikalische Eigenschaften der Scaneinheit. Bei dem Schritt 5.II wird auf Basis der Hardwareparameter HP ein Imperfektionsmodell IM, welches das nicht-ideale physikalische Verhalten der individuellen Scaneinheit modellhaft wiedergibt, ermittelt. Bei dem Schritt 5.III wird auf Basis des Imperfektionsmodells IM ein Kompensationsmodell KM, das mindestens einen Kompensationsmechanismus, der auf dem jeweiligen Imperfektionsmodell IM beruht bzw. gerade so ausgebildet ist, dass die durch das betreffende Imperfektionsmodell IM ermittelte Abweichung durch das Kompensationsmodell KM aufgehoben bzw. kompensiert wird, ermittelt. Bei dem Schritt 5.IV werden einer Applikation zugeordnete Applikationsdaten AD empfangen. Bei dem Schritt 5.V werden kompensierte Applikationsdaten KAD auf Basis der empfangenen Applikationsdaten AD und dem ermittelten Kompensationsmodell KM ermittelt. Bei dem Schritt 5.VI wird eine Pulssequenz PS über eine Scaneinheit auf Basis der kompensierten Applikationsdaten KAD ausgespielt. Bei dem Schritt 5.VII werden Rohdaten RD von einem Untersuchungsbereich erfasst. Schließlich werden bei dem Schritt 5.VIII Bilddaten BD auf Basis der Rohdaten RD rekonstruiert und einem Benutzer angezeigt.

Es wird abschließend noch einmal darauf hingewiesen, dass es sich bei den vorbeschriebenen Verfahren und Vorrichtungen lediglich um bevorzugte Ausführungsbeispiele der Erfindung handelt und dass die Erfindung vom Fachmann variiert werden kann, ohne den Bereich der Erfindung zu verlassen, soweit er durch die Ansprüche vorgegeben ist.

Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können.

## Patentansprüche

1. MR-System-Kompensationsschnittstelle (20), aufweisend:
- eine Hardware-Subschnittstelle (21) zum Empfangen von individuellen Hardwareparametern (HP) von einer individuellen Scaneinheit (102) eines MR-Systems (200),
- eine Modellermittlungseinheit (22), welche dazu eingerichtet ist, ein Imperfektionsmodell (IM) auf Basis der Hardwareparameter (HP) zu ermitteln,
- eine Kompensationsmodell-Ermittlungseinheit (23) zum Ermitteln eines Kompensationsmodells (KM) auf Basis des Imperfektionsmodells (IM),
- eine Applikations-Subschnittstelle (24) zum Empfangen von einer Applikation zugeordneten Applikationsdaten (AD),
- eine Kompensationseinheit (25) zum Ermitteln von kompensierten Applikationsdaten (KAD) auf Basis der empfangenen Applikationsdaten (AD) und dem ermittelten Kompensationsmodell (KM).

2. MR-System-Kompensationsschnittstelle nach Anspruch 1, wobei die Kompensationsmodell-Ermittlungseinheit (23) dazu eingerichtet ist, durch die Applikationsdaten (AD) festgelegte Werte für zeitliche Abfolgen und zeitliche Abstände der Applikation unverändert aufrechtzuerhalten.

3. MR-System-Kompensationsschnittstelle nach Anspruch 1 oder 2, wobei das Imperfektionsmodell (IM) mindestens einen der folgenden Modelltypen umfasst:
- ein physikalisches Modell,
- ein trainiertes Modell.

4. MR-System-Kompensationsschnittstelle nach einem der vorstehenden Ansprüche, wobei das Imperfektionsmodell (IM) eine Mehrzahl von trainierten Modellen umfasst, die jeweils einem unterschiedlichen physikalischen Effekt zugeordnet sind.

5. MR-System-Kompensationsschnittstelle nach einem der Ansprüche 1 bis 3, wobei das Imperfektionsmodell (IM) ein einziges trainiertes Modell umfasst.

6. MR-System-Kompensationsschnittstelle nach einem der vorstehenden Ansprüche, wobei
- das Kompensationsmodell (KM) zu einer bestimmten Imperfektion eine Mehrzahl von Kompensations-Algorithmen aufweist und
- die Kompensationseinheit (25) dazu eingerichtet ist, auf Basis der Applikationsdaten (AD) einen der Mehrzahl von Kompensations-Algorithmen auszuwählen.

7. MR-System-Kompensationsschnittstelle nach einem der vorstehenden Ansprüche, wobei die Kompensationsmodell-Ermittlungseinheit (23) dazu eingerichtet ist, das Kompensationsmodell (KM) auf Basis der Applikationsdaten (AD) zu ermitteln.

8. MR-System-Kompensationsschnittstelle nach einem der vorstehenden Ansprüche, wobei die Kompensationsmodell-Ermittlungseinheit (23) dazu eingerichtet ist, das Kompensationsmodell (KM) in Abhängigkeit von einer spezifischen Hardware und/oder einer bestimmten Software-Lizenz zu ermitteln.

9. MR-System-Kompensationsschnittstelle nach einem der Ansprüche 6 bis 8, wobei
- die Applikations-Subschnittstelle (24) als Dialogschnittstelle ausgebildet ist, um der Applikation und/oder einem Benutzer mitzuteilen, welcher Kompensations-Algorithmus verfügbar ist und/oder
- die MR-System-Kompensationsschnittstelle (20) dazu eingerichtet ist, in Abhängigkeit von dem ermittelten Kompensationsmodell (KM) einen Dialog zwischen einer Bedienperson und einer universellen Scaneinheit-Schnittstelle (2) zu gestalten.

10. MR-System-Kompensationsschnittstelle nach einem der vorstehenden Ansprüche, wobei die Kompensationseinheit (25) dazu ausgebildet ist, die zeitliche Abfolge und/oder Dauer einer von den Applikationsdaten (AD) umfassten Applikation zu ändern.

11. MR-System-Steuereinrichtung (13), aufweisend:
- eine Applikationseinheit (1),
- eine Scaneinheit-Schnittstelle (2),
- eine MR-System-Kompensationsschnittstelle (20) nach einem der Ansprüche 1 bis 10.

12. Magnetresonanzbildgebungssystem (200), umfassend eine MR-System-Steuereinrichtung (13) nach Anspruch 11.

13. Verfahren zur Ermittlung einer kompensierten Ansteuersequenz eines MR-Systems (200) zur Erzeugung von Magnetresonanzbilddaten (BD) eines Untersuchungsobjekts (O), aufweisend die Schritte:
- Empfangen von individuellen Hardwareparametern (HP) von einer individuellen Scaneinheit (102) des MR-Systems (200),
- Ermitteln eines Imperfektionsmodells (IM) auf Basis der Hardwareparameter (HP),
- Ermitteln eines Kompensationsmodells (KM) auf Basis des Imperfektionsmodells (IM),
- Empfangen von einer Applikation zugeordneten Applikationsdaten (AD),
- Ermitteln von kompensierten Applikationsdaten (KAD) auf Basis der empfangenen Applikationsdaten (AD) und dem ermittelten Kompensationsmodell (KM).

14. Computerprogrammprodukt mit einem Computerprogramm, welches direkt in eine Speichereinrichtung einer Steuereinrichtung (13) eines Magnetresonanzbildgebungssystems (200) ladbar ist, mit Programmabschnitten, um alle Schritte des Verfahrens nach Anspruch 13 auszuführen, wenn das Computerprogramm in der Steuereinrichtung (13) des Magnetresonanzbildgebungssystems (200) ausgeführt wird.

15. Computerlesbares Medium, auf welchem von einer Rechnereinheit eines Magnetresonanzbildgebungssystems (200) einlesbare und ausführbare Programmabschnitte gespeichert sind, um alle Schritte des Verfahrens nach Anspruch 13 auszuführen, wenn die Programmabschnitte von der Rechnereinheit ausgeführt werden.
